(19) Europäisches Patentamt
European Patent Office
Office européen des brevets

(11) **EP 3 746 801 B1**

(12) **FASCICULE DE BREVET EUROPEEN**

(45) Date de publication et mention de la délivrance du brevet:
**16.08.2023 Bulletin 2023/33**

(21) Numéro de dépôt: **19701680.1**

(22) Date de dépôt: **31.01.2019**

(51) Classification Internationale des Brevets (IPC):
***G01R 19/12*** *(2006.01)*

(52) Classification Coopérative des Brevets (CPC):
**G01R 19/12**

(86) Numéro de dépôt international:
**PCT/EP2019/052429**

(87) Numéro de publication internationale:
**WO 2019/149846 (08.08.2019 Gazette 2019/32)**

(54) **CAPTEUR DE VITESSE DE VARIATION INSTANTANEE DE COURANT GALVANIQUEMENT ISOLE ET INTEGRE SUR UNE CARTE DE CIRCUIT IMPRIME**

SENSOR, DER DIE MOMENTANE ÄNDERUNGSGESCHWINDIGKEIT EINES STROMES ERFASST, WOBEI DIESER SENSOR GALVANISCH ISOLIERT UND IN EINE LEITERPLATTE INTEGRIERT IST

SENSOR WHICH SENSES THE INSTANTANEOUS RATE OF CHANGE OF A CURRENT, SAID SENSOR BEING GALVANICALLY ISOLATED AND INTEGRATED ON A PRINTED CIRCUIT BOARD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.01.2018 FR 1850773**
**23.02.2018 FR 1851598**

(43) Date de publication de la demande:
**09.12.2020 Bulletin 2020/50**

(73) Titulaires:
• **NL CONSEIL**
**92530 Le Plessis-Robinson (FR)**
• **Safran Electrical & Power**
**31702 Blagnac (FR)**

(72) Inventeur: **LARTIGUE, Norbert**
**92350 LE PLESSIS-ROBINSON (FR)**

(74) Mandataire: **Gevers & Orès**
**Immeuble le Palatin 2**
**3 Cours du Triangle**
**CS 80165**
**92939 Paris La Défense Cedex (FR)**

(56) Documents cités:
**US-A- 5 777 417      US-A1- 2010 176 793**
**US-A1- 2014 306 551      US-A1- 2015 204 914**
**US-A1- 2017 104 338**

## Description

DOMAINE DE L'INVENTION

La présente invention concerne un capteur de vitesse de variation instantanée de courant intégré dans un circuit imprimé. Elle concerne plus particulièrement une amélioration d'un capteur de type transformateur à l'air comprenant des conducteurs et des bobines. Ce capteur est particulièrement adapté à la mesure sur des courants de bras de pont d'un module de puissance et à leur protection. En se référant à la topologie des circuits électriques elle adresse en particulier la mesure des courants aux noeuds de plusieurs conducteurs.

Etat de la technique

L'état de la technique est illustré par les documents US 2009/0001962 A1, US 2006/0038552 A1, US 2017/0104338 A1 et US 2015/0204914 A1.

La conversion d'énergie en électronique de puissance est en pleine mutation. Ce dynamisme est tiré par les différentes révolutions qui ont lieu dans les secteurs automobile (véhicules hybrides et tout électrique, bornes de recharge), ferroviaire (accroissement du niveau d'intégration de l'électronique des trains, nouvelles sous stations plus efficaces énergétiquement), aéronautique (avion plus électrique), spatial (arrivée du numérique dans la conversion d'énergie), industrie (amélioration de l'efficacité énergétique des usines où on se branche sur le réseau sans convertisseur...), énergie (intégration des énergies renouvelables, super-réseau, micro-réseau).

Ce développement nouveau de l'électronique de puissance est rendu possible grâce aux nouvelles technologies des modules de puissance, comme transistor bipolaire à porte isolée (insolated gate bipolar transistor en anglais, IGBT) et semi-conducteur à grand écart comme GaN et SiC, qui ont permis d'accroître les rendements et les niveaux d'intégration des « fonctions électrifiées ». En contrepartie, la température à l'intérieur de ces modules atteint des sommets (> 125°C, jusqu'à 255°C).

Les modules de puissance sont constitués de bras de pont, dont les temps de commutation deviennent très courts grâce aux composants « à grand écart ». On parle typiquement de couper 100A en 10ns. Comme conséquences, les règles de design doivent permettre de réduire les inductances parasites, afin de limiter les surtensions et de réduire les énergies piégées dans les éléments inductifs des circuits commutés.

Pour autant, il peut toujours y avoir un défaut dans le bras et/ou dans la charge, défaut dont il faut anticiper la détection avant que des surintensités prohibitives ne soient atteintes. Par conséquent, il est nécessaire d'avoir un capteur de courant capable de mesurer des variations temporelles extrêmement rapides de courants dès leur établissement notamment dans les bras de pont des convertisseurs statique d'énergie afin d'anticiper la détection d'un défaut ; le capteur devra naturellement résister thermiquement et mécaniquement à ces courants de défauts. Le défaut doit typiquement être détecté en quelques centaines de nanosecondes dès l'apparition du défaut et avant l'établissement subséquentes de surintensités prohibitives afin de pouvoir ouvrir le circuit électrique du bras dans un délai typiquement inférieur à 1μs. Ce capteur de courant ne doit pas introduire d'inductance parasite de valeur supérieure à quelques nH.

On connaît de US 2009/0001962 A1 un capteur de courant comprenant des bobines situées à l'intérieur de la puce de circuit intégré et couplées de manière inductive à un conducteur situé dans le boîtier de circuit. Les inductances détectent le courant dans le conducteur et fournissent le signal détecté à un intégrateur qui fournit une tension indicative du courant dans le conducteur.

On connaît également du document US 2006/0038552 A1 un équipement de détection de courant qui comprend une première bobine et une seconde bobine connectées en série avec la première bobine. L'équipement de détection de courant est capable de détecter un courant circulant à travers un objet qui est prévu entre les premières et secondes bobines ou prévu à proximité de la première ou de la seconde bobine. Chacune des première et seconde bobines ayant des premiers motifs conducteurs prévus sur une surface d'un substrat, des deuxièmes motifs conducteurs prévus sur un dos du substrat et des pièces de connexion qui relient les premier et second motifs conducteurs. Un dispositif à semi-conducteur comprenant l'équipement de détection de courant pour mesurer le courant circulant dans un élément semi-conducteur est également proposé. On connaît de US 2017/0104338 A1 un circuit intégré comprenant des moyens de mesure, ayant au moins une bobine, pour détecter la vitesse de variation du courant d'un dispositif de puissance. On connaît également de US 2015/0204914 A1 un dispositif de mesure des courants qui traversent trois conducteurs.

Il est évident pour l'homme de l'art de trouver une topologie à trois dimensions, par exemple en orientant les trois terminaux dans les trois axes d'un repère orthonormé à trois dimensions. On peut réaliser une mesure de champ dans chacun des plans du repère et ainsi bénéficier d'une relative immunité entre les trois courants des trois terminaux. Cependant, ce principe est très difficile et coûteux à mettre en oeuvre pratiquement, et notamment en ce qui concerne les contraintes d'optimisation de la longueur des conducteurs requise pour la minimisation impérieuse des inductances parasites.

Il est souhaitable de résoudre plusieurs problèmes comme :

- mesurer simultanément et séparément les di/dt développés dans un bras de pont et dans sa charge,
- disposer d'une mesure physique directe de la vitesse de variation de courant afin de permettre un traitement rapide de l'information brute la plus exempte possible de bruit.
- minimiser l'inductance parasite éventuellement introduite dans le circuit de commutation,
- avoir un temps de réponse très court,
- être très compact, idéalement intégré dans une carte de circuit imprimé (PCB en anglais) et être compatible avec un modèle dont les composants sont montés en surface,
- être insensible aux très forts dV/dt,
- Assurer une isolation galvanique,
- Etre immunisé contre les perturbations électromagnétiques, notamment la diaphonie générées par les autres bras de pont (cas d'un pont complet ou d'un pont triphasé par exemple) et par les autres circuits de puissance voisins.

## BREVE DESCRIPTION DE L'INVENTION

En vue de la réalisation de l'un au moins de ces buts, l'objet de l'invention propose un capteur de vitesse de variation instantanée de courant. Le capteur se caractérise en ce qu'il comprend au moins trois conducteurs (C1, C2, Cp) et des bobines. Le capteur présente en outre les caractéristiques come décrites ci-après :

- une extrémité de chacun desdits conducteurs est connectée à un noeud commun (N),
- et l'autre extrémité de chacun desdits conducteurs est utilisée respectivement chacune comme un terminal électrique (T1, T2, Tp),
- lesdits au moins trois conducteurs sont contenus dans un même plan, appelé le plan primaire (P),
- chaque conducteur (C1, C2, Cp) présente un plan de symétrie (P1, P2, Pp) perpendiculaires au plan primaire, chacun plan de symétrie passant par le noeud commun (N) et le terminal correspondant (T1, T2, Tp),
- un premier conducteur (C1) et un deuxième conducteur (C2) sont identiques et positionnés symétriquement par rapport à un troisième conducteur (Cp),
- au moins une paire de bobines sont positionnées symétriquement par rapport à un plan de symétrie (P1, P2, Pp) .

Selon d'autres caractéristiques avantageuses et non limitatives de l'invention, prises seules ou selon toute combinaison techniquement réalisable :

- Au moins deux plans de symétrie coïncident,
- le premier conducteur et le deuxième conducteur sont alignés et la distance entre les terminaux correspondants est minimale,
- une des bobines du troisième conducteur est commune avec une des bobines du premier conducteur, et l'autre des bobines du troisième conducteur est commune avec une des bobines du deuxième conducteur,
- Les conducteurs sont de forme rectiligne et plane,
- Les conducteurs sont multicouches ou striés,
- Les conducteurs (C1, C2, Cp) et les bobines sont réalisés en circuit imprimé multicouche,
- Les conducteurs (C1, C2, Cp) sont multipistes et multicouches présent une topologie de type « barres de Roebel» couramment mises en oeuvre dans les machines électriques pour réduire les courants de Foucault à l'origine de l'augmentation de la résistance et de l'inductance internes des conducteurs à haute fréquence.
- La topologie décrite a pour effet de positionner une couche conductrice virtuelle équivalente au regard des phénomènes magnétiques dans la zone de la mi épaisseur du plan des conducteurs,
- Le capteur comprend des écrans électrostatiques gravés en circuit imprimé multicouche et reliés à un potentiel fixe entre les couches de puissance et les couches de mesure,
- les écrans sont gravés de façon à canaliser judicieusement les courants de Foucault,
- Toutes les couches de puissance sont regroupées dans un plan à un premier niveau, et toutes les couches de mesure sont regroupées dans un plan à un deuxième niveau, le premier niveau étant soit au-dessus, soit au-dessous du deuxième niveau.

## BREVE DESCRIPTION DES DESSINS

D'autres caractéristiques et avantages de l'invention ressortiront de la description détaillée de l'invention qui va suivre en référence aux figures annexées sur lesquels :

- la figure 1 représente une vue schématique d'un capteur de vitesse de variation instantanée de courant pour la mesure de trois courants ;

- la figure 2 représente une vue schématique d'un capteur de vitesse de variation instantanée de courant pour la mesure de courant de bras de pont et du courant de phase d'une topologie de convertisseur de type pont ;
- la figure 3 représente une vue schématique d'un capteur de vitesse de variation instantanée de courant pour la mesure du courant de bras de pont.

DESCRIPTION DETAILLEE DE L'INVENTION

Par souci de simplification de la description à venir, les mêmes références sont utilisées pour des éléments identiques ou assurant la même fonction dans les différentes variantes du dispositif décrit.

Exemple de réalisation pour la mesure de trois courants

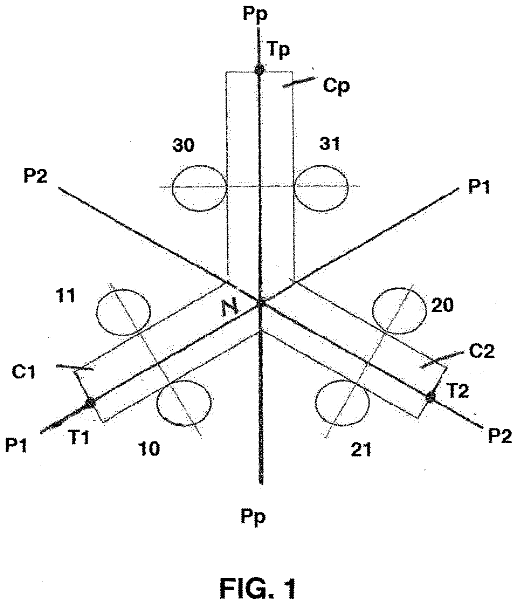

La figure 1 illustre un premier mode de réalisation d'un capteur pour la mesure instantanée de trois vitesses de variation instantanée de courants dans une structure de tri-pôle. C'est un capteur de vitesse de variation instantanée de courant comprenant trois conducteurs C1, C2, Cp. Une extrémité de chaque conducteur est connectée à un noeud commun N, tandis que l'autre extrémité de chaque conducteur est définie comme un terminal électronique T1, T2, Tp. On note alors les trois terminaux Tp, T1 et T2 parcourus par les courants Ip, I1 et I2.

Tous les trois conducteurs sont sensiblement contenus dans le même plan, qui est sur le plan du papier, appelé le plan primaire. Il est en outre défini pour le conducteur Cp un plan de symétrie Pp, qui traverse la ligne entre le noeud N et le terminal Tp, et qui est perpendiculaire au plan primaire. Une paire de bobines 30 et 31 est positionnée symétriquement par rapport au plan Pp et chacune d'un côté du conducteur Cp. De la même manière, des plans de symétrie P1 et P2 perpendiculaires au plan primaire sont définis respectivement par rapport aux conducteurs C1 et C2, le plan de symétrie P1 passant par la ligne entre le noeud N en le terminal T1, le plan de symétrie P2 passant par la ligne entre le noeud N en le terminal T2.

Une paire de bobines 10 et 11 est positionnée symétriquement par rapport au plan P1 et chacune d'un côté du conducteur C1, tandis qu'une paire de bobines 20 et 21 est positionnée symétriquement par rapport au plan P2 et chacune d'un côté du conducteur C2. Dans chaque paire de bobines, l'une est câblée dans la direction gauche, l'autre dans la direction droite, ces bobines sont appelées: Sp1D 10, Sp1G 11, Sp2D 20, Sp2G 21, SppD 30 et SppG 31.

On obtient par exemple la mesure de la vitesse de variation instantanée du courant Ip, indépendamment de la valeur de I1 et I2, via la force électromotrice délivrée par la bobine constituée des combinaisons suivantes :

- SppD en série, SppG en anti-série

- Sp1G en anti-série, Sp1D en anti-série

- Sp2G en série, Sp2D en série

De la même façon, on obtient la valeur de la vitesse de variation instantanée de I1 indépendamment des 2 autres courants respectivement via les combinaisons suivantes :

- SppD en antisérie, SppG en antisérie

- Sp1G en antisérie, Sp1D en série

- Sp2G en série, Sp2D en série

Et pour la vitesse de variation de I2 :

- SppD en antisérie, SppG en antisérie

- Sp1G en série, Sp1D en série

- Sp2G en série, Sp2D en antisérie

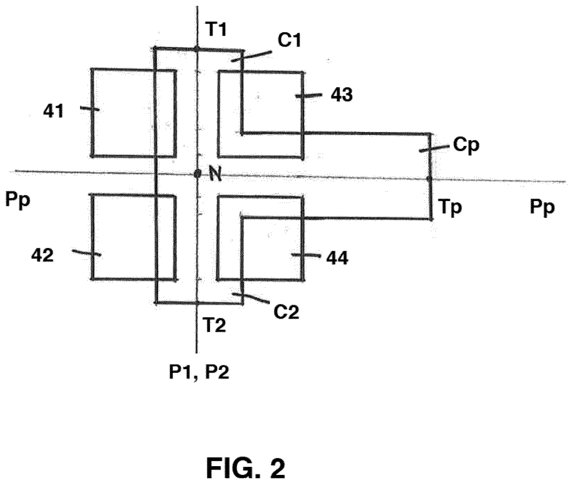

Dans ce cas de réalisation, les bobines de forme circulaire sont données à titre illustratif mais pas limitatif.
Exemple de capteur de vitesse de variation instantanée de courant de bras de pont et de courant de phase
La figure 2 illustre un deuxième mode de réalisation d'un capteur pour mesurer la vitesse de variation instantanée de courant de bras de pont et de courant de phase. C'est un capteur de courant comprenant trois conducteurs C1, C2, Cp. Les conducteurs C1 et C2 sont identiques, alignés et positionnés de façon symétrique et perpendiculaire par rapport au conducteur Cp. Une extrémité de chaque conducteur est connectée à un noeud commun N, tandis que l'autre extrémité de chaque conducteur est définie comme un terminal électrique T1, T2, Tp. Le terminal T1 est parcouru par un courant I1, le terminal T2 par le courant I2 et le terminal Tp par le courant Ip. Par définition les courants sont entrants.

Tous les trois conducteurs sont contenus dans le même plan, qui est sur le plan du papier, appelé le plan primaire. De manière similaire que dans le premier mode de réalisation, il est défini également trois plans de symétrie P1, P2 et Pp perpendiculaires au plan primaire pour chaque conducteur C1, C2 et Cp. Lorsque les conducteurs C1 et C2 sont alignés, les plans de symétrie P1 et P2 se confondent.

Une paire de bobines 43 et 44 est positionnée symétriquement par rapport au plan Pp et chacune d'un côté du conducteur Cp. Chacun des conducteurs C1 et C2 possède respectivement une bobine 41 et 42 sur son côté. Par symétrie, la paire de bobines 41 et 43 sont positionnées symétriquement par rapport au plan P1 et chacune d'un côté du conducteur C1, tandis que la paire de bobines 42 et 44 est positionnée symétriquement par rapport au plan P2 et chacune d'un côté du conducteur C2.

Les quatre bobines sont orientées par définition dans une direction perpendiculaire au plan primaire, avec un flux positif allant vers le haut du papier.

Les bobines sont représentées avec une forme carrée à titre illustratif mais pas limitatif. Elles peuvent être rectangulaires, circulaires, etc tant qu'elles respectent la symétrie.

Il est introduit douze inductances mutuelles entre les circuits C1, C2 et Cp et chacune des quatre bobines, notées Mxxy, avec xx représentant la bobine et y représentant le courant. Les valeurs des inductances sont positives par définition.

On peut calculer le flux dans chaque bobine par superposition et écrire les équations suivantes :

$$\text{Phi1D} = - \text{M1D1.I1} + \text{M1D2.I2} - \text{M1Dp.Ip}$$

$$\text{PhipD} = \text{MpD1.I1} - \text{MpD2.I2} - \text{MpDp.Ip}$$

$$\text{PhipG} = \text{MpG1.I1} - \text{MpG2.I2} + \text{MpGp.Ip}$$

$$\text{Phi2G} = - \text{M2G1.I1} + \text{M2G2.I2} + \text{M2Gp.Ip}$$

Grâce aux symétries de construction, on peut simplifier le jeu d'équations.

En effet, de par la symétrie des bobines par rapport au plan Pp, on a les propriétés:

$$\text{MpGp} = \text{MpDp} = \text{Mpp}$$

$$\text{M2Gp} = \text{M1Dp} = \text{Mip}$$

En effet, de par la symétrie des bobines par rapport au plan P1, on a les propriétés:

$$\text{M1D1} = \text{MpD1} = \text{Mii}$$

$$\text{M2G1} = \text{MpG1} = \text{Mij}$$

En effet, de par la symétrie des bobines par rapport au plan P2, on a les propriétés:

$$\text{M2G2} = \text{MpG2} = \text{Mii}$$

$$\text{M1D2} = \text{MpD2} = \text{Mji}$$

Par ailleurs, grâce à la symétrie des conducteurs C1 et C2 par rapport au plan Pp, on ajoute la propriété

$$Mij = Mji$$

On se retrouve avec un système de 4 équations avec seulement 4 paramètres de fabrication, notés Mii, Mji et Mpp, Mip.

A savoir :

```
Phi1D =  - Mii . I1     + Mji. I2 - Mip . Ip

PhipD =  + Mii . I1      - Mji. I2 - Mpp . Ip

PhipG =  + Mji . I1      - Mii. I2 + Mpp . Ip

Phi2G =  - Mji . I1      + Mii. I2 + Mip . Ip
```

Il est défini de la façon suivante le courant de mode commun IMC et le courant de mode différentiel IMD :

$$IMC = \frac{I1 + I2}{2}$$

$$IMD = \frac{I1 - I2}{2}$$

Ainsi $I_1$ = IMC+IMD
Et $I_2$ = IMC-ID

Et rappelons la loi des noeuds : Ip = - $I_1$ - $I_2$
Ainsi Ip = -2 IMC
Ainsi on constate que le courant de phase est une image du courant de mode commun, tandis que le courant de bras est une image du courant de mode différentiel.
Rappelons également que la force électromotrice aux bornes d'une bobine est proportionnelle à la dérivée par rapport au temps du flux capté. Ainsi, une différence de tension aux bornes des bobines apparaît, directement proportionnelle à la vitesse de variation des courants voisins à l'origine des flux.
Réécrivons les équations de flux pour faire apparaître les deux courants IMC et IMD :

```
Phi1D = - Mii.( IMC+IMD) + Mji.(IMC-IMD) + 2 Mip.IMC

PhipD = + Mii.( IMC+IMD) - Mji.(IMC-IMD) + 2 Mpp.IMC

PhipG = + Mji.( IMC+IMD) - Mii.(IMC-IMD) - 2 Mpp.IMC

Phi2G = - Mji.( IMC+IMD) + Mii.(IMC-IMD) - 2 Mip.IMC
```

Calculons maintenant le flux de la bobine SpMC constituée par la combinaison suivante :

- SpID en série

- SppD en anti-série

- SppG en série

- Sp2G en anti-série

Cette combinaison est intéressante car elle est constituée d'une paire doublement différentielle, qui réjecte donc particulièrement tous les flux issus des champs externes.

On obtient un flux complet, noté PhiMC, suivant :

$$
\begin{aligned}
\text{PhiMC} = \; & - \text{Mii.( IMC+IMD)} + \text{Mji.(IMC-IMD)} + 2\ \text{Mip.IMC} \\
& - \text{Mii.( IMC+IMD)} + \text{Mji.(IMC-IMD)} - 2\ \text{Mpp.IMC} \\
& + \text{Mji.( IMC+IMD)} - \text{Mii.(IMC-IMD)} - 2\ \text{Mpp.IMC} \\
& + \text{Mji.( IMC+IMD)} - \text{Mii.(IMC-IMD)} + 2\ \text{Mip.IMC}
\end{aligned}
$$

$$
\begin{aligned}
\text{PhiMC} = \; & -2\ \text{Mii.( IMC+IMD)} + 2\ \text{Mji.(IMC-IMD)} + 4\ \text{Mip.IMC} \\
& + 2\ \text{Mji.( IMC+IMD)} - 2\ \text{Mii.(IMC-IMD} - 4\ \text{Mpp.IMC}
\end{aligned}
$$

$$
\begin{aligned}
\text{PhiMC} = \; & \text{IMC.}(-2\ \text{Mii} + 2\ \text{Mji} + 4\ \text{Mip} \\
& \qquad\qquad\qquad - 4\ \text{Mpp} + 2\ \text{Mji} - 2\ \text{Mii}) \\
& + \text{IMD.}(-2\ \text{Mii} - 2\ \text{Mji} + 2\ \text{Mji} + 2\ \text{Mii})
\end{aligned}
$$

$$
\text{PhiMC} = \text{IMC.}(-4\ \text{Mii} + 4\text{Mji} + 4\ \text{Mip} - 4\ \text{Mpp})
$$

$$
\text{PhiMC} = 2\text{Ip.}(-\text{Mii} + \text{Mji} + \text{Mip} - \text{Mpp})
$$

PhiMC ne dépend pas de courant de mode différentiel (IMD), qui est l'image du courant de bras, mais il dépend seulement de courant de mode commun (IMC), qui est l'image du courant de phase. Ainsi, cette topologie permet-elle de d'accéder au courant de phase indépendamment du courant de bras.

Calculons maintenant le flux de la spire SpMD constituée par la combinaison suivante :

- SplD en série

- SppD en antisérie

- SppG en antisérie

- Sp2G en série

Cette combinaison est intéressante car elle est constituée d'une paire différentielle, qui réjecte bien l'influence des champs externes.

On obtient un flux complet, noté PhiMD, suivant :

$$
\begin{aligned}
\text{PhiMD} = \; & - \text{Mii.( IMC+IMD)} + \text{Mji.(IMC-IMD)} + 2\ \text{Mip.IMC} \\
& - \text{Mii.( IMC+IMD)} + \text{Mji.(IMC-IMD)} - 2\ \text{Mpp.IMC} \\
& - \text{Mji.( IMC+IMD)} + \text{Mii.(IMC-IMD)} + 2\ \text{Mpp.IMC} \\
& - \text{Mji.( IMC+IMD)} + \text{Mii.(IMC-IMD)} - 2\ \text{Mip.IMC}
\end{aligned}
$$

$$\text{PhiMD} = + 4(\text{Mji} + \text{Mii}).\text{IMD}$$

$$\text{PhiMD} = + 2(\text{Mji} + \text{Mii}).(\text{I1--I2})$$

PhiMD ne dépend pas du courant de mode commun (IMC), qui est l'image du courant de phase, mais seulement de courant de mode différentiel (IMD), qui est l'image du courant de bras. Ainsi, cette topologie permet-elle d'accéder au courant de bras indépendamment du courant de phase.

Exemple de capteur de vitesse de variation instantanée de courant de bras de pont

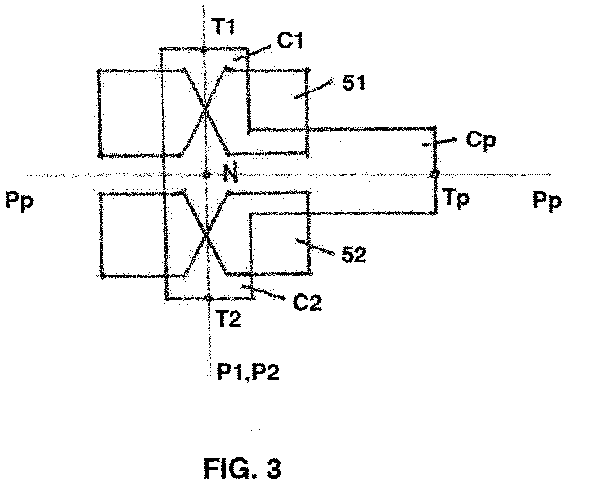

La figure 3 illustre un troisième mode de réalisation d'un capteur pour mesurer la vitesse de variation instantanée de courant de bras de pont et de courant de phase. Les conducteurs sont les mêmes que ceux du deuxième mode de réalisation. Une paire de bobines 51 et 52 est positionnée symétriquement par rapport aux plans P1, P2 et Pp, et chacune d'un côté du conducteur Cp. Dans cet exemple, seul le courant de phase est mesuré, indépendamment du courant de bras de pont.

Les paragraphes suivants introduisent plusieurs variantes du capteur de vitesse de variation instantanée de courant fondé sur la structure principale susvisée.

D'abord on considère une configuration qui introduit une très faible inductance parasite dans le circuit de commutation.

si on considère que le courant de phase est Ip, seule l'inductance entre les terminaux 1 et 2 intervient dans le comportement de la commutation d'un bras de pont. On peut chercher à privilégier cette valeur d'inductance, auquel cas on peut réduire la distance entre les terminaux 1 et 2 et le noeud. Dans cette configuration, la distance entre les terminaux T1 et T2 est minimale afin de réduire l'inductance. Par conséquent, il n'est pas possible de séparer les courants I1 et I2. Lorsque l'on privilégie des pistes conductrices larges et courtes sur le circuit imprimé, tout en conservant la symétrie, on atteint des faibles valeurs d'inductance, typiquement inférieures à 10nH, voire à 5nH, voire à 2nH, voire à 1nH.

Bien que l'on perde la possibilité de mesurer indépendamment les courants des deux demi-bras T1-Tp et T2-Tp, on peut toujours obtenir le courant de bras et de phase.

Concernant un autre mode de réalisation, il est souhaitable d'obtenir un temps de réponse très court, typiquement inférieur à 300ns, voire à 100ns. Pour réduire le temps de réponse, il faut réduire au maximum les constantes de temps introduites par effet de peau et de proximité. Pour cela, on privilégiera des conducteurs électriques C1, C2 et Cp comme des conducteurs primaires, qui sont réalisés en multicouches, avec chacune des couches isolées les unes des autres. Un PCB multicouche est un bon exemple pour la réalisation des conducteurs primaires.

De plus, pour chaque couche, on peut strier les conducteurs. Ainsi, les conducteurs primaires C1, C2 et Cp sont multicouches et/ou striés.

De plus, les conducteurs C1, C2 et Cp peuvent être réalisés suivant une topologie de type barres de Roebel(Roebel bar en anglais), qui représente une division spéciale d'un conducteur électrique en forme de tige en une pluralité de sous-conducteurs parallèles, isolés les uns des autres et stratifiés. Cette topologie permet aux conducteurs de se comporter globalement comme un seul conducteur plan, et de réduire considérablement les effets des courants de Foucault sur la valeur de la résistance et sur la valeur de l'inductance des conducteurs aux fréquences élevées.

Selon un autre aspect, l'invention propose un capteur de vitesse de variation instantanée de courant compact, idéalement intégré dans un circuit imprimé. On réalise ici les conducteurs primaires C1, C2 et CP en gravant des pistes sur une carte de circuit imprimé (PCB « Printed Circuit Board » en anglais). Afin de maîtriser les règles de symétrie, on réalise également les bobines du capteur sur le même PCB avec des couches éloignées.

On peut utiliser plusieurs bobines du capteur, telles que décrites précédemment, pour délivrer directement les forces électromotrice induites (f.e.m) sans avoir à réaliser de post traitement. Ainsi on aura une couche pour la bobine délivrant la f.e.m proportionnelle à la vitesse de variation instantanée du courant de phase et une autre couche pour la bobine délivrant la f.e.m induite image de la vitesse de variation instantanée du courant de bras de pont. Les conducteurs C1, C2 et Cp ainsi que les bobinages sont réalisés en PCB multicouches.

Selon un autre aspect encore, l'invention propose un capteur de vitesse de variation instantanée de courant compatible avec un modèle dont les composants sont montés en surface (CMS).

Il suffit de situer toutes les couches du PCB de puissance sous les couches de mesure. Les pistes de puissance sont regroupées sensiblement dans le même plan et les pistes de mesure dans un seul et même autre plan parallèle, placé soit au dessus, soit au dessous.

Selon un aspect particulier, l'invention propose un capteur de courant immunisé contre de très forts dV/dt, typiquement supérieur à 10kV/$\mu$s, voire à 100kV/1$\mu$s, voire à 1MV/us.

La tension au niveau des points milieu du bras de pont subit de très fort dV/dt par rapport au point froid des potentiels. Des courants peuvent être de ce fait injectés dans l'électronique des capteurs par effet capacitif. A priori, ce sont des courants de mode commun liés aux variations de potentiel de mode commun du point milieu du bras par rapport au point froid de la source continue alimentant le pont convertisseur. Ainsi apparaît l'intérêt d'utiliser une mesure différentielle afin d'éliminer les effets de ces courants sur la mesure. Cependant, il reste néanmoins un risque correspondant à l'injection de courants très élevés dans les circuits électroniques bas niveau et qui pourra les détruire.

Pour réduire ce risque, on utilise un écran électrostatique, par exemple de type Faraday, entre les conducteurs primaires et les bobines de mesure. Cet écran peut être réalisé en PCB via une couche de cuivre supplémentaire. On peut choisir d'introduire ou pas une nouvelle constante de temps en prenant en compte la création de courants de Foucault. Pour cela, les écrans sont gravés de façon à canaliser judicieusement les courants de Foucault qui peuvent y prendre naissance. De plus, on doit maîtriser la conductivité de cet écran via son épaisseur ou l'utilisation de stries dans certaines directions privilégiées de nature à contrôler le développement des courants de Foucault dans l'écran. Les écrans électrostatiques peuvent être reliés à un potentiel fixe, entre les couches de puissance et de mesure, afin de dériver judicieusement les courants parasites.

L'invention porte également sur un capteur de vitesse de variation instantanée de courant qui assure une isolation galvanique, typiquement la tension assignée d'isolement est de 1kV, voire 10kV et des tensions de claquage supérieure à 10kV, voire supérieure à 20kV, voire à 50kV.

Il suffit de maîtriser la distance entre les circuits de puissance et de mesure, via des matériaux dont la tension de claquage correspond à l'objectif désiré. Cela est réalisé en technologie PCB avec des matériaux isolants, par exemple des résines époxy.

Selon un mode de réalisation, l'invention porte sur un capteur de vitesse de variation instantanée de courant immunisé contre les perturbations électromagnétiques, notamment la diaphonie générée par les autres bras de pont (cas d'un pont complet ou d'un pont triphasé par exemple). Cela est réalisé via la structure différentielle des bobines de mesure qui réjectent tous les phénomènes électromagnétiques présentant un mode commun entre les deux bobines.

## Revendications

1. Capteur de vitesse de variation de courant pour la protection des bras de pont dans un module de puissance avec des couches de puissance et des couches de mesures, le capteur de vitesse de variation de courant comprenant au moins trois conducteurs (C1, C2, Cp) et des bobines, et étant **caractérisé en ce que**:

   - une extrémité de chacun desdits conducteurs est connectée à un noeud commun (N),
   - et l'autre extrémité de chacun desdits conducteurs est utilisée respectivement chacune comme un terminal électrique (T1, T2, Tp),
   - lesdits au moins trois conducteurs sont contenus dans un même plan, appelé le plan primaire (P),
   - chaque conducteur (C1, C2, Cp) présente un plan de symétrie (P1, P2, Pp) perpendiculaires au plan primaire, chacun plan de symétrie passant par le noeud commun (N) et le terminal correspondant (T1, T2, Tp),
   - un premier conducteur (C1) et un deuxième conducteur (C2) sont identiques et positionnés symétriquement par rapport à un troisième conducteur (Cp),
   - au moins une paire de bobines (10, 11 et/ou 20, 21 et/ou, 30, 31) sont positionnées symétriquement par rapport à un plan de symétrie (P1, P2, Pp).

2. Capteur de vitesse de variation de courant selon la revendication 1 dans lequel le premier conducteur (C1) et le deuxième conducteur (C2) sont alignés et la distance entre les terminaux correspondants (T1, T2) est minimale.

3. Capteur de vitesse de variation de courant selon l'une quelconque des revendications précédentes dans lequel chacune des bobines du troisième conducteur (Cp) est constituée une des bobines du premier conducteur ou du deuxième conducteur.

4. Capteur de vitesse de variation de courant selon l'une quelconque des revendications précédentes dans lequel les conducteurs sont en forme rectiligne et plane.

5. Capteur de vitesse de variation de courant selon l'une quelconque des revendications précédentes dans lequel les conducteurs sont multicouches et/ou striés.

6. Capteur de vitesse de variation de courant selon l'une quelconque des revendications précédentes dans lequel les conducteurs présentent une topologie de réalisation de type barres de Roebel.

**7.** Capteur de vitesse de variation de courant selon l'une quelconque des revendications précédentes dans lequel les conducteurs (C1, C2, Cp) et les bobines sont réalisés en circuit imprimé multicouche.

**8.** Capteur de vitesse de variation de courant selon l'une quelconque des revendications précédentes comprenant en outre des écrans électrostatiques gravés en circuit imprimé multicouche et reliés à un potentiel fixe entre les couches de puissance et les couches de mesure.

**9.** Capteur de vitesse de variation de courant selon la revendication 8 dans lequel les écrans sont gravés de façon à canaliser judicieusement les courants de Foucault.

**10.** Capteur de vitesse de variation de courant selon l'une quelconque des revendications précédentes dans lequel toutes les couches de puissance sont regroupées dans un plan à un premier niveau, et toutes les couches de mesure sont regroupées dans un plan à un deuxième niveau, le premier niveau soit au-dessus, soit au-dessous du deuxième niveau.

**Patentansprüche**

**1.** Sensor für die Änderungsgeschwindigkeit von Strom zum Schutz der Brückenarme in einem Leistungsmodul mit Leistungsschichten und Messschichten,
wobei der Stromänderungsgeschwindigkeitssensor mindestens drei Leiter (C1, C2, Cp) und Spulen umfasst und **dadurch gekennzeichnet ist, dass**:

- ein Ende jedes der Leiter mit einem gemeinsamen Knoten (N) verbunden ist,
- und das andere Ende jedes der Leiter jeweils als elektrischer Anschluss (T1, T2, Tp) verwendet wird,
- die mindestens drei Leiter in ein und derselben Ebene, der sogenannten Primärebene (P), enthalten sind,
- jeder Leiter (C1, C2, Cp) eine Symmetrieebene (P1, P2, Pp) aufweist, die senkrecht zur Primärebene stehen, wobei jede Symmetrieebene durch den gemeinsamen Knoten (N) und den entsprechenden Anschluss (T1, T2, Tp) verläuft,
- ein erster Leiter (C1) und ein zweiter Leiter (C2) identisch und in Bezug auf einen dritten Leiter (Cp) symmetrisch positioniert sind,
- mindestens ein Paar Spulen (10, 11 und/oder 20, 21 und/oder 30, 31) in Bezug auf eine Symmetrieebene (P1, P2, Pp) symmetrisch positioniert sind.

**2.** Stromänderungsgeschwindigkeitssensor nach Anspruch 1, wobei der erste Leiter (C1) und der zweite Leiter (C2) ausgerichtet sind und der Abstand zwischen den entsprechenden Anschlüssen (T1, T2) minimal ist.

**3.** Stromänderungsgeschwindigkeitssensor nach einem der vorstehenden Ansprüche, wobei jede der Spulen des dritten Leiters (Cp) aus einer der Spulen des ersten Leiters oder des zweiten Leiters besteht.

**4.** Stromänderungsgeschwindigkeitssensor nach einem der vorstehenden Ansprüche, wobei die Leiter eine geradlinige und ebene Form aufweisen.

**5.** Stromänderungsgeschwindigkeitssensor nach einem der vorstehenden Ansprüche, wobei die Leiter mehrschichtig und/oder gestreift sind.

**6.** Stromänderungsgeschwindigkeitssensor nach einem der vorstehenden Ansprüche, wobei die Leiter eine Ausführungstopologie vom Typ Roebelstäbe aufweisen.

**7.** Stromänderungsgeschwindigkeitssensor nach einem der vorstehenden Ansprüche, wobei die Leiter (C1, C2, Cp) und die Spulen als mehrschichtige gedruckte Schaltung ausgeführt sind.

**8.** Stromänderungsgeschwindigkeitssensor nach einem der vorstehenden Ansprüche, weiter elektrostatische Abschirmungen umfassend, die als mehrschichtige gedruckte Schaltung geätzt und mit einem festen Potential zwischen den Leistungsschichten und den Messschichten verbunden sind.

**9.** Stromänderungsgeschwindigkeitssensor nach Anspruch 8, wobei die Abschirmungen so geätzt sind, dass sie die Wirbelströme sinnvoll kanalisieren.

**10.** Stromänderungsgeschwindigkeitssensor nach einem der vorstehenden Ansprüche, wobei alle Leistungsschichten in einer Ebene auf einem ersten Niveau zusammengefasst sind, und alle Messschichten in einer Ebene auf einem zweiten Niveau zusammengefasst sind, wobei das erste Niveau entweder über oder unter dem zweiten Niveau liegt.

**Claims**

**1.** A current change rate sensor for protecting the bridge arms in a power module with power layers and measurement layers, the current change rate sensor comprising at least three conductors (C1, C2, Cp) and coils, **characterized in that** :

- one end of each of said conductors is connected to a common node (N),
- and the other end of each of said conductors is used respectively each as an electrical terminal (T1, T2, Tp),
- said at least three conductors are contained in a same plane, called the primary plane (P),
- each conductor (C1, C2, Cp) has a plane of symmetry (P1, P2, Pp) perpendicular to the primary plane, each plane of symmetry passing through the common node (N) and the corresponding terminal (T1, T2, Tp),
- a first conductor (C1) and a second conductor (C2) are identical and positioned symmetrically with respect to a third conductor (Cp),
- at least one pair of coils (10, 11 and/or 20, 21 and/or, 30, 31) are positioned symmetrically with respect to a plane of symmetry (P1, P2, Pp).

**2.** The current change rate sensor according to claim 1, wherein the first conductor (C1) and the second conductor (C2) are aligned and the distance between the corresponding terminals (T1, T2) is minimal.

**3.** The current change rate sensor according to any one of the preceding claims wherein each of the coils of the third conductor (Cp) is constituted by one of the coils of the first conductor or the second conductor.

**4.** The current change rate sensor according to any one of the preceding claims wherein the conductors are in a rectilinear and flat shape.

**5.** The current change rate sensor according to any one of the preceding claims, wherein the conductors are multilayer and/or striated.

**6.** The current change rate sensor according to any one of the preceding claims, wherein the conductors have a Roebel bar type construction topology.

**7.** The current change rate sensor according to any one of the preceding claims wherein the conductors (C1, C2, Cp) and the coils are made of a multilayer printed circuit.

**8.** The current change rate sensor according to any one of the preceding claims comprising electrostatic shields etched in a multilayer printed circuit and connected to a fixed potential between the power layers and the measurement layers.

**9.** The current change rate sensor according to claim 8 wherein the shields are etched so as to judiciously channel the eddy currents.

**10.** The current change rate sensor according to any one of the preceding claims wherein all the power layers are gathered in a plane at a first level, and all the measurement layers are gathered in a plane at a second level, the first level either above or below the second level.

FIG. 1

**FIG. 2**

**FIG. 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090001962 A1
- US 20060038552 A1
- US 20170104338 A1
- US 20150204914 A1